# EUROPEAN PATENT APPLICATION

(11) **EP 2 931 008 A1**
(43) Date of publication of application: **14.10.2015**
(21) Application number: 13861374.0
(22) Date of filing: 06.12.2013
(51) Int. Cl.: H05K 1/09, H05K 3/46, H05K 7/20

(54) **PRINTED CIRCUIT BOARD AND MANUFACTURING METHOD THEREFOR**

(30) Priority: 07.12.2012 KR 20120141576
(71) Applicant: Tyco Electronics AMP Korea Ltd., Gyeongsangbuk-do 712-837 (KR)
(72) Inventor: CHOI, Yang Yoon, Gyeongsangbuk-do 712-837 (KR); BEAK, Ok Ky, Siheung-si Gyeonggi-do 429-854 (KR)
(74) Representative: Johnstone, Douglas Ian
(86) International application number: PCT/KR2013/011247
(87) International publication number: WO 2014/088357

(57) **Abstract**

Disclosed are a printed circuit board capable of increasing heat dissipation and bending strength by using aluminum and a manufacturing method therefor. The printed circuit board comprises: a double-sided substrate which comprises an insulation layer of an insulating material, a base layer which is bonded on either side of the insulation layer and has a circuit pattern formed on the surface thereof and is made of an aluminum material, and a bonding member interposed to bond the base layer to the insulation layer; a second insulation layer formed on the base layer of the double-sided substrate; a second base layer which is bonded on the second insulation layer by means of a second bonding member; a via hole which penetrates the double-sided substrate, the second insulation layer, and the second base layer; a substitution layer formed by the surface treatment of zincifying the surface of the second base layer and the exposed inner part of the via hole; a plating layer formed on the substitution layer; and a second circuit pattern formed on the plating layer.

## Description

### Technical Field

The present invention relates to a printed circuit board (PCB) using aluminum and a method of manufacturing the PCB that may increase heat dissipation and bending strength using the aluminum.

### Background Art

In general, a printed circuit board (PCB) is a component in which electric wirings are integrated to allow various devices to be populated therein or to be electrically connected to one another. Technological developments have lead to an increase in production of PCBs having various forms and functions. A demand for such PCBs has been increasing with a growth of industries using the PCBs and relating to, for example, home appliances, communication devices, semiconductor equipment, industrial machinery, and electrical control of a vehicle. In addition, PCB products are being transformed into a miniaturized, light-weight, and high value-added product as electronic components become smaller and more sophisticated.

A predominant feature of such electronic components may be discovered in that various added complex functions consume a considerable amount of power and generate a greater amount of heat. Thus, a degree of heat generated from an electronic product may be a factor used to evaluate a degree of satisfaction with the electronic product and a standard of purchasing.

Conventionally, a multilayer PCB is manufactured by using a copper-clad laminate (CCL) as a base substrate, forming a circuit pattern on the CCL, and additionally laminating a layer. However, improving a heat dissipation characteristic of the PCB due to limited available materials, for example, copper (Cu), through such a conventional method of manufacturing the multilayer PCB may be limited.

Recently, developments have been made to manufacture PCBs using aluminum (Al) having a more desirable thermal conductivity than Cu. An example of technology for manufacturing such PCBs is discovered in patent documents 1 and 2 to be described in the following.

Patent document 1 entitled "PCB with enhanced radiating ability and the manufacturing method thereof' discloses a PCB and a method of manufacturing the PCB to improve a radiating characteristic of a substrate, which is limited when using the conventional CCL substrate, by using an aluminum substrate as a base substrate. The PCB disclosed in patent document 1 includes an aluminum core, a circuit pattern formed therein, a central layer having an etching resist pattern formed on both faces thereof, an insulation layer displaced on both faces of the central layer, an additional circuit layer displaced on the insulation layer and having a circuit pattern formed thereon, a via hole penetrating the aluminum core, the insulation layer, and the additional circuit layer, and a zinc plating layer formed on an inner wall of the via hole by performing zincate treatment, and a plating layer formed on the substrate through copper plating to electrically connect the layers together.

Patent document 2 discloses a method of substituting aluminum for an insulation layer and forming a circuit on both sides to improve a bending reinforcing performance. The method disclosed in patent document 2 includes forming surface roughness and changing to a nonconductor through via hole treatment, and closely contacting anodized aluminum to a plating layer of a via hole, and forming a circuit on both aluminum faces. In addition, patent documents 2 includes a description that a desirable anodizing depth may be in a range of 10 to 100 micrometers (µm), and no electrical shock may occur and a desirable insulating function may be achieved in an anodizing depth of 30 µm.

### Documents of related arts (patent documents)

Korean Patent Registration No. 10-0674321 (registered on January 18,2007)
Japanese Patent Publication No. 2004-179291 (published on June 24,2004)

### Disclosure of Invention

### Technical Goals

The aforementioned method of manufacturing a printed circuit board (PCB) using an aluminum core may have an issue in that a surface of the aluminum core may be corroded during electroless copper plating because an aluminum material included in the aluminum core of the PCB has a lower chemical resistance compared to conventionally used copper. In such a case, a copper film formed during the electroless copper plating may not be in a complete contact with a lower portion of the aluminum core, and a surface of the copper film may be lifted and a poor adhesion may be resulted therefrom after electrolytic copper plating to be subsequently performed. Thus, reliability of a product may decrease.

When used for office automation equipment, portable terminals, and the like having a relatively stable temperature range for application, the PCB manufactured using such a conventional technology may have a stable adhesion to the copper film due to the anodizing performed on the aluminum core. However, when applied to an electronic control for a vehicle, for example, an engine room, the PCB may have an issue of a decreasing adhesion between a thin aluminum film and the copper film due to a harsh environment.

In addition, when being applied to a vehicle, the PCB may have an issue in that the PCB may be damaged by a difference in a thermal expansion coefficient between the aluminum core and another layer disposed on the aluminum core due to a high temperature.

Patent document 1 discloses a method of layering an insulator on both sides of a semi-processed aluminum substrate. In such a method, the aluminum substrate may be connected due to a characteristic of a circuit etching process and thus, an independent portion or circuit may not be formed. In addition, an entire layer may be limited to a certain electrode, (+) or (-), when applying an electric current. Thus, a great number of processes may be required to manufacture a multilayer PCB and an issue may occur in integrating a circuit and simplifying a product.

To handle such issues described in the foregoing, an aspect of the present invention provides a PCB and a method of manufacturing the PCB to increase a heat dissipation function and bending strength.

Another aspect of the present invention provides a PCB and a method of manufacturing the PCB to reduce a weight of electronic components for a vehicle by using aluminum relatively lighter than copper.

Still another aspect of the present invention provides a PCB and a method of manufacturing the PCB to reduce an amount of time and cost for manufacturing the PCB.

Yet another aspect of the present invention provides a PCB and a method of manufacturing the PCB to manufacture various forms of circuits as necessary based on aluminum bonded onto an insulation layer by a method of disposing aluminum on the insulation layer, and to simplify a product by integrating a circuit in accordance with the method.

### Technical Solutions

According to an aspect of the present invention, there is provided a printed circuit board (PCB) including a double-sided substrate including an insulation layer of an insulating material, a base layer of an aluminum material which is bonded on both sides of the insulation layer and including a circuit pattern on a surface of the base layer, and a bonding member interposed to bond the base layer to the insulation layer, and a second insulation layer formed on the base layer of the double-sided substrate, a second base layer bonded to the second insulation layer using a second bonding member, a via hole formed to penetrate the double-sided substrate, the second insulation layer, and the second base layer, and a substitution layer formed by performing surface treatment to zincify a surface of the second base layer and a portion exposed to an inner side of the via hole, a plating layer formed on the substitution layer, and a second circuit pattern formed on the plating layer.

The PCB may further include a metal layer formed by metalizing a surface of the insulation layer and the bonding member of the double-sided substrate and the second insulation layer and the second bonding member, which is exposed to the inner side of the via hole. The plating layer may be formed to cover the metal layer. A zincate process may be performed on the substitution layer to substitute zinc for a surface of the base layer. The substitution layer may be formed to have a thickness equal to a thickness of the metal layer. The plating layer may be formed using electrolytic or electroless plating. The plating layer may include a substitution plating layer formed on a surface of the substitution layer through the electrolytic or the electroless plating, and an electrolytic plating layer of a cupric material formed on the substitution plating layer through the electrolytic plating. The substitution plating layer may be formed to fully cover the metal layer, and the electrolytic plating layer may be formed to cover the substitution plating layer. Alternatively, the substitution plating layer may be formed on the substitution layer apart from the metal layer or formed to cover a portion of the metal layer, and the electrolytic plating layer may be formed to cover a portion of the metal layer on which the substitution plating layer is not formed.

At least one or at least two double-sided substrates may be layered. At least two double-sided substrates may be layered and an insulation layer may be formed between the double-sided substrates.

The base layer may be formed of an aluminum material, and surface treatment may be performed to form surface roughness of the base layer.

The circuit pattern may be formed through any one of a chemical method and a mechanical method, or formed as a hole.

According to another aspect of the present invention, there is provided a method of manufacturing a printed circuit board (PCB), the method including providing an insulation layer of an insulating material, bonding a base layer having a predetermined thickness to the insulation layer using a bonding member, forming a double-sided substrate by forming a predetermined circuit pattern on the base layer, forming a second insulation layer to fill the circuit pattern of the double-sided substrate, bonding a second base layer of an aluminum material to the second insulation layer using a second bonding member, forming a via hole penetrating the double-sided substrate, the second insulation layer, the second bonding member, and the second base layer, and forming a substitution layer by performing surface treatment to zincify a surface of the second base layer and a portion exposed to an inner side of the via hole, forming a plating layer on the substitution layer using electrolytic or electroless plating, and forming a second circuit pattern on the plating layer.

Subsequent to the forming of the via hole, the method may further include forming a metal layer by metalizing a surface of the insulation layer and the bonding member of the double-sided substrate and the second insulation layer and the second bonding member, which is exposed to the inner side of the via hole. The plating layer may be formed to cover the metal layer. The forming of the substitution layer may include forming the substitution layer to have a thickness equal to a thickness of the metal layer. The forming of the substitution layer may include substituting zinc for a surface of the base layer and the insulation layer using a zincate method. The forming of the plating layer may include forming the plating layer to cover a portion or an entirety of the metal layer. The forming of the plating layer may include forming a substitution plating layer on a surface of the substitution layer using electrolytic or electroless plating, and forming an electrolytic plating layer of a cupric material on the substitution plating layer using the electrolytic plating.

The method may further include forming surface roughness of the base layer prior to the bonding of the base layer to the insulation layer.

According to still another aspect of the present invention, there is provided a method of manufacturing a printed circuit board (PCB), the method including providing an insulation layer of an insulating material, bonding a base layer having a predetermined thickness to the insulation layer using a bonding member, forming a double-sided substrate by forming a predetermined circuit pattern on the base layer, layering at least two double-sided substrates on which the circuit pattern is formed, forming an insulation layer between the layered double-sided substrates and on each of an upper face and a lower face of the layered double-sided substrates, bonding a second base layer of an aluminum material to each of the upper face and the lower face of the layered double-sided substrates using a second bonding member, forming a via hole penetrating the layered double-sided substrates, the second insulation layer, the second bonding member, and the second base layer, and forming a substitution layer by performing surface treatment to zincify a surface of the second base layer and a portion exposed to an inner side of the via hole, forming a plating layer on the substitution layer using electrolytic or electroless plating, and forming a circuit pattern on the plating layer.

Subsequent to the forming of the via hole, the method may further include forming a metal layer to metalize a face of the insulation layer and the bonding member of the double-sided substrate, and the second insulation layer and the second bonding member, which is exposed to the inner side of the via hole. The forming of the substitution layer may include forming the substitution layer to have a thickness equal to a thickness of the metal layer based on the thickness of the metal layer.

The forming of the substitution layer may include substituting zinc for a surface of the base layer and the insulation layer using a zincate method.

The forming of the plating layer may include forming a substitution plating layer on a surface of the substitution layer using electrolytic or electroless plating, and forming an electrolytic plating layer of a cupric material on the substitution plating layer using the electrolytic plating.

Prior to the bonding of the base layer to the insulation layer, the method may further include forming surface roughness of the base layer.

### Effects of Invention

According to embodiments of the present invention, using a polyimide bonding sheet that may absorb a change rate based on a thermal expansion coefficient of aluminum may prevent damage to a substrate despite a severe condition of a drastic change in vibration and temperature and thus, may improve reliability of a product.

According to embodiments of the present invention, a printed circuit board (PCB) and a method of manufacturing the PCB may enable formation of surface roughness of a base layer, reduction in an amount of time for manufacturing the PCB, and reduction in a cost for manufacturing the PCB using a relatively inexpensive aluminum.

According to embodiments of the present invention, a PCB and a method of manufacturing the PCB may enable reduction in a cost for manufacturing the PCB by applying an existing layering, plating, and circuit forming method, and enable improvement in current carrying, heat dissipation, and bending strength.

According to embodiments of the present invention, a PCB and a method of manufacturing the PCB may enable implementation of various forms of circuits as necessary, circuit integration, and product simplification.

### Brief Description of Drawings

FIGS. 1 through 6 are mimetic diagrams illustrating a method of manufacturing a printed circuit board (PCB) according to embodiments of the present invention.

FIGS. 7 through 12 are mimetic diagrams illustrating a method of manufacturing a multilayer PCB using the PCB manufactured using the method described with reference to FIGS. 1 through 6 according to embodiments of the present invention.

### Best Mode for Carrying Out Invention

Reference will now be made in detail to embodiments of the present invention, examples of which are illustrated in the accompanying drawings, wherein like reference numerals refer to the like elements throughout. The embodiments are described below in order to explain the present invention by referring to the figures. In descriptions of illustrative examples provided herein, known functions or configurations may be omitted to clearly deliver a point of the present invention.

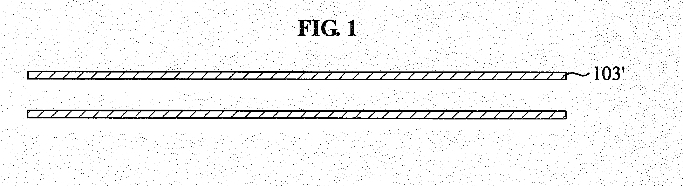

Hereinafter, a method of manufacturing a printed circuit board (PCB) will be described in detail with reference to FIGS. 1 through 6. Unless indicated otherwise, a phrase "on a layer" may refer to "on both an upper face and a lower face of the layer."

Referring to FIG 1, a base layer 103' formed as an aluminum foil having a predetermined thickness is prepared. To improve a bonding performance of the base layer 103', soft etching may be performed on a surface of the base layer 103' using a sulfuric acid type, or oxidation treatment may be performed to form surface roughness of the base layer 103'.

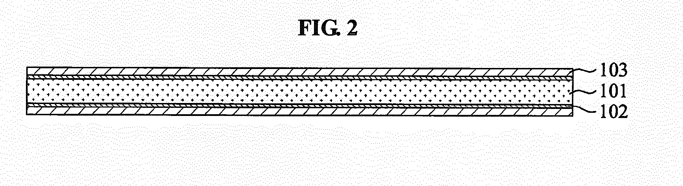

Referring to FIG 2, a base layer 103 on which the surface roughness is formed is bonded onto both an upper face and a lower face of an insulation layer 101 of an insulating material using a bonding member 102. For example, a polyimide-based insulating bonding sheet, which is a binder having a desirable bonding performance and insulating function, or an epoxy type such as glass epoxy resin may be used for the bonding member 102. A material having a thermal expansion coefficient similar to a thermal expansion coefficient of the base layer 103 may be used for the bonding member 102. Here, since polyimide endures at a high temperature of 400 °C or above or at a low temperature of -269 °C, the polyimide may absorb a change rate based on a thermal expansion coefficient of aluminum, for example, 23.03 x 10-6 °C. To bond the base layer 103 onto the insulation layer 101, a predetermined temperature and pressure may be applied to the base layer 103.

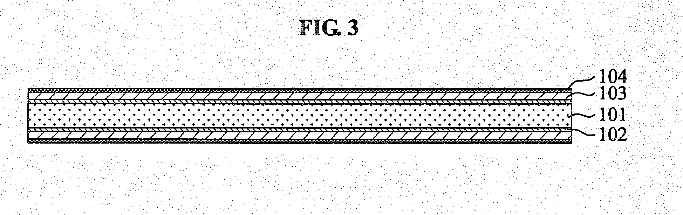

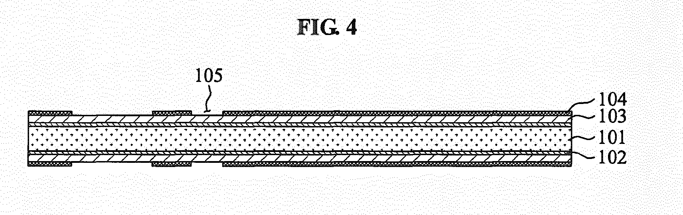

Referring to FIG. 3, a dry film 104 is applied onto the base layer 103. Referring to FIG. 4, a pattern 105 is formed through light exposure and development for a predetermined amount of time.

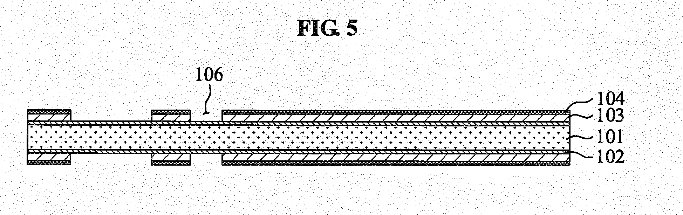

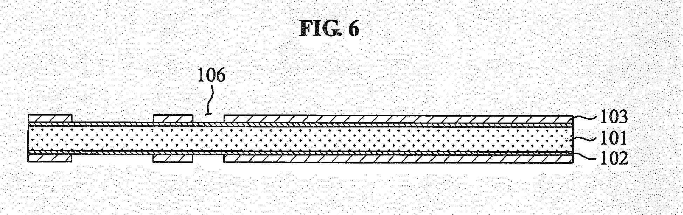

Referring to FIG. 5, a circuit pattern 106 is formed by removing the base layer 103 based on the pattern 105 of the dry film 104. Referring to FIG. 6, a PCB is formed by removing the dry film 104 from the base layer 103 on which the circuit pattern 106 is formed. The circuit pattern 106 is formed by selectively removing a portion of the base layer 103 exposed by the pattern 105 using hydrochloric acid-based acidic etching in a state in which the dry film 104 is connected to the base layer 103. Here, a hydrochloric acid type, for example, ferric chloride, cupric chloride, and sodium chlorate, may be used.

Although forming the circuit pattern 106 directly on the base layer 103 is illustrated as an example, the present invention may not be limited thereto. Alternatively, the circuit pattern 106 may be formed on a plating layer after the plating layer is formed on the base layer 103 using electrolytic or electroless plating.

Although a chemical method used to form the circuit pattern 106 is illustrated as an example, the present invention may not be limited thereto. Alternatively, a mechanical method using punching and the like may be used to form the circuit pattern 106. Alternatively, only a through hole may be formed to connect an electrode or a metal layer in lieu of the circuit pattern 106.

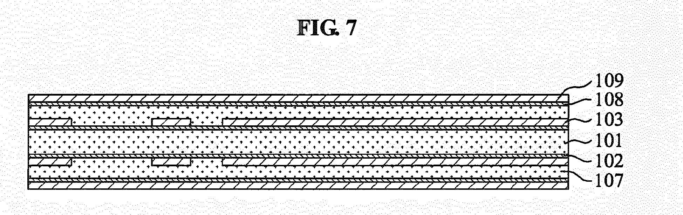

FIGS. 7 through 12 are mimetic diagrams illustrating a method of manufacturing a multilayer PCB using the PCB manufactured in accordance with the method described with reference to FIGS. 1 through 6. Hereinafter, for ease of description, the PCB manufactured in accordance with the method described with reference to FIGS. 1 through 6 will be referred to as a double-sided substrate.

Referring to FIG 7, an insulation layer 107 having a predetermined thickness is formed to fill the circuit pattern 106 in the double-sided substrate manufactured in accordance with the method described with reference to FIGS. 1 through 6. A base layer 109 is bonded onto the insulation layer 107 using a bonding member 108. For example, the base layer 109 may be an aluminum foil having a predetermined thickness. A polyimide-based insulating bonding sheet or an epoxy type may be used for the bonding member 108.

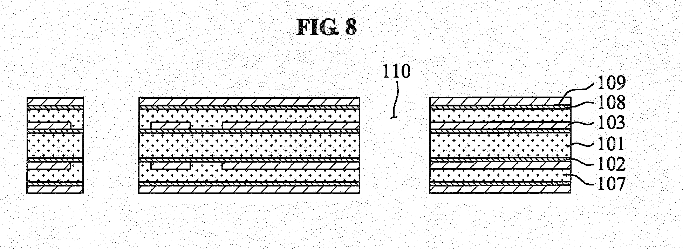

Referring to FIG. 8, a via hole 110 is formed to penetrate all the double-sided substrate, the insulation layer 107, the bonding member 108, and the base layer 109. For example, the via hole 110 may be formed by drilling or laser processing.

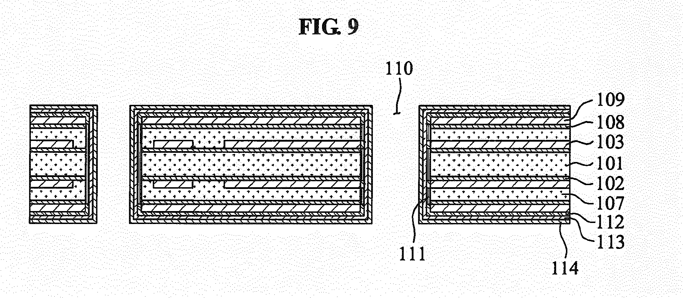

Referring to FIG. 9, in a state in which the via hole 110 is formed, a metal layer 111 is formed to metalize a cross-sectional portion of the insulation layers 101 and 107 and the bonding members 102 and 108, which is exposed to an inner side of the via hole 110. For example, the metal layer 111 may form a carbon plating layer using carbon direct plating. With the formation of the metal layer 111, the base layers 103 and 109 are electrically connected.

Subsequently, a substitution layer 112 having a predetermined thickness is formed by performing zincate treatment on a surface of the base layer 109 from which the metal layer 111 is excluded. The substitution layer 112 is formed by a portion of the surface of the base layer 109 being substituted by a zinc film. The thickness of the substitution layer 112 is formed to be equal to a thickness of the meal layer 111 based on the thickness of the metal layer 111. With the formation of the substitution layer 112, the substitution layer 112 having the thickness is formed on a remaining surface of the base layer 109 from which the metal layer 111 is excluded. In addition, with the formation of the substitution layer 112, aluminum may be prevented from being oxidized in an atmosphere and thus, the surface of the base layer 109 may be protected. Further, with the surface of the base layer 109 being substituted by the zinc film, the surface of the base layer 109 may be prevented from being corroded during electrolytic and electroless plating to be subsequently performed.

A substitution plating layer 113 is formed on the substitution layer 112 using the electrolytic or the electroless plating. Here, the substitution plating layer 113 is formed on the substitution layer 112 by performing displacement plating using a metal film having a strong chemical resistance. For example, the substitution plating layer 113 may be formed by performing the displacement plating using nickel (Ni) and substituting a nickel film for the substitution layer 112. However, the displacement plating may not be limited to using nickel. Alternatively, other metals having a strong chemical resistance, for example, gold (Au) and silver (Ag), may be used for the displacement plating.

Although a case in which a partial thickness of the substitution layer 112 is substituted by the nickel film through the nickel displacement plating is illustrated, the present invention may not be limited thereto. Alternatively, a case in which both the metal layer 111 and the substitution layer 112 are substituted by the substitution plating layer 113 may be considered. The substitution plating layer 113 may be formed only on the substitution layer 112 apart from the metal layer 111, or formed to cover a portion or an entirety of the metal layer 111.

An electrolytic plating layer 114 is formed on the substitution plating layer 113. The electrolytic plating layer 114 is formed also on the substitution plating layer 113 in the via hole 110. For example, the electrolytic plating layer 114 may be a copper film through copper plating. In addition, the electrolytic plating layer 114 is formed using the electrolytic plating. For example, the electrolytic plating layer 114 may be formed to have a thickness of greater than or equal to 20 micrometers (µm).

Here, at least one of the substitution plating layer 113 and the electrolytic plating layer 114 is formed on a surface of the metal layer 111. In detail, when the substitution plating layer 113 is formed only on the substitution layer 112 apart from the metal layer 111, the electrolytic plating layer 114 is formed to cover all the substitution plating layer 113 and the metal layer 111, and only the electrolytic plating layer 114 is formed on the metal layer 111. When the substitution plating layer 113 is formed to cover a portion of the metal layer 111, the electrolytic plating layer 114 is formed to cover all the substitution plating layer 113 and the metal layer 111. When the substitution plating layer 113 is formed to fully cover the metal layer 111, the electrolytic plating layer 114 covers the substitution plating layer 113 and thus, two layers, the substitution plating layer 113 and the electrolytic plating layer 114, are formed on the metal layer 111.

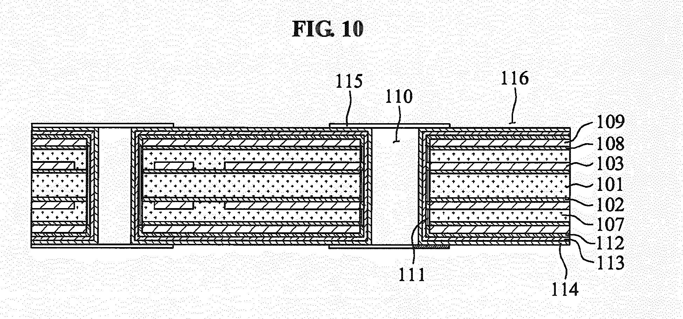

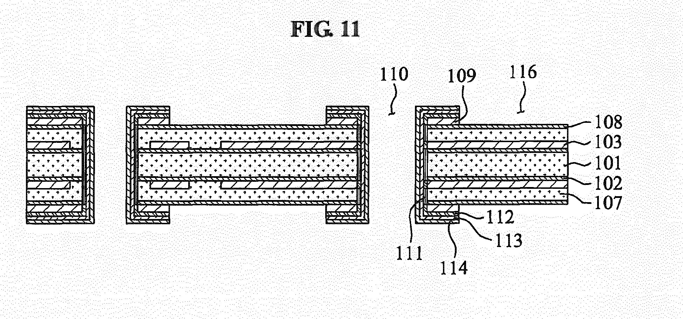

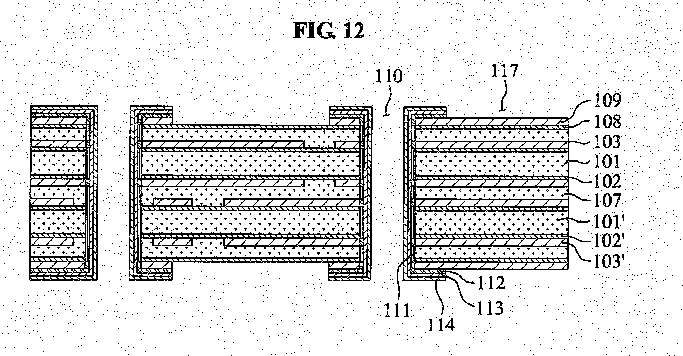

Referring to FIG 10, a pattern 116 is formed by applying a dry film 115 onto the electrolytic plating layer 114 and performing light exposure and development for a predetermined amount of time. Referring to FIGS. 11 and 12, a circuit pattern 117 is formed by removing the electrolytic plating layer 114, the substitution plating layer 113, the substitution layer 112, and the base layer 109 using the dry film 115 on which the pattern 116 is formed. Here, the circuit pattern 117 is formed by removing the electrolytic plating layer 114, the substitution plating layer 113, the substitution layer 112, and up to the base layer 109 through hydrochloric acid-based acidic etching using the dry film 115. For a method of forming the circuit pattern 117 by applying the dry film 115 and forming the pattern 116, reference may be made to the descriptions of such a method provided in the foregoing and thus, repeated descriptions are omitted here for brevity.

Although example embodiments described in the foregoing relate to forming a double-layer double-sided substrate, the present invention may not be limited thereto. A multilayer PCB, for example, triple or more layered substrate, may be formed by repetitively performing operations described with reference to FIGS. 7 through 11. Alternatively, a higher multiple layered PCB may be formed by layering at least three double-sided substrates through operations to be described with reference to FIG. 12.

FIG. 12 illustrates a multilayer PCB formed by layering at least two double-sided substrates manufactured through the method described with reference to FIGS. 1 through 6. Here, an insulation layer 107 is interposed between the double-sided substrates to be layered to electrically separate the double-sided substrates. In a state in which the double-sided substrates are layered, the insulation layer 107, a bonding member 108, and a base layer 109 are formed on each of an uppermost face and a lowermost face of the double-sided substrates. By applying the method described with reference to FIS. 7 through 11, a via hole is formed, and then the metal layer 111, the substitution layer 112, the substitution plating layer 113, and the electrolytic plating layer 114 are sequentially formed. Subsequently, a high multiple layer substrate, which is the multilayer PCB, is formed by forming the circuit pattern 117 using the dry film 115.

Here, the circuit pattern 117 is formed through a chemical method using the hydrochloric acid-based acidic etching using the dry film 115. The chemical method may be used to form the circuit pattern 117 by selectively removing a layer, for example, removing up to the second base layer 109 in addition to the electrolytic plating layer 114, the substitution plating layer 113, and the substitution layer 112.

In addition to the chemical method using a dry film and hydrochloric acid-based acidic etching, a mechanical method using punching and the like may be used to form a pattern on a base layer to be layered in the high multiple layer substrate. Further, only a through hole may be formed to connect an electrode or a metal layer in a predetermined form.

A PCB manufactured in accordance with example embodiments described herein may be applicable to an electronic component for a vehicle.

While this disclosure includes specific examples, it will be apparent to one of ordinary skill in the art that various changes in form and details may be made in these examples without departing from the spirit and scope of the claims and their equivalents. The examples described herein are to be considered in a descriptive sense only, and not for purposes of limitation. Descriptions of features or aspects in each example are to be considered as being applicable to similar features or aspects in other examples. Suitable results may be achieved if the described techniques are performed in a different order, and/or if components in a described system, architecture, device, or circuit are combined in a different manner and/or replaced or supplemented by other components or their equivalents.

Therefore, the scope of the disclosure is defined not by the detailed description, but by the claims and their equivalents, and all variations within the scope of the claims and their equivalents are to be construed as being included in the disclosure.

## Claims

1. A printed circuit board (PCB), comprising:
a double-sided substrate comprising an insulation layer of an insulating material, a base layer of an aluminum material which is bonded on both sides of the insulation layer and comprising a circuit pattern on a surface of the base layer, and a bonding member interposed to bond the base layer to the insulation layer;
a second insulation layer formed on the base layer of the double-sided substrate;
a second base layer bonded to the second insulation layer using a second bonding member;
a via hole formed to penetrate the double-sided substrate, the second insulation layer, and the second base layer;
a substitution layer formed by performing surface treatment to zincify a surface of the second base layer and a portion exposed to an inner side of the via hole;
a plating layer formed on the substitution layer; and
a second circuit pattern formed on the plating layer.

2. The PCB of claim 1, further comprising:
a metal layer formed by metalizing a surface of the insulation layer and the bonding member of the double-sided substrate and the second insulation layer and the second bonding member, which is exposed to the inner side of the via hole, and
wherein the plating layer is formed to cover the metal layer.

3. The PCB of claim 2, wherein a zincate process is performed on the substitution layer to substitute zinc for a surface of the base layer, and
the substitution layer is formed to have a thickness equal to a thickness of the metal layer.

4. The PCB of claim 3, wherein the plating layer is formed using electrolytic or electroless plating.

5. The PCB of claim 4, wherein the plating layer comprises a substitution plating layer formed on a surface of the substitution layer through the electrolytic or the electroless plating, and an electrolytic plating layer of a cupric material formed on the substitution plating layer through the electrolytic plating.

6. The PCB of claim 5, wherein the substitution plating layer is formed to fully cover the metal layer, and
the electrolytic plating layer is formed to cover the substitution plating layer.

7. The PCB of claim 5, wherein the substitution plating layer is formed on the substitution layer apart from the metal layer, or formed to cover a portion of the metal layer, and
the electrolytic plating layer is formed to cover a portion of the metal layer on which the substitution plating layer is not formed.

8. The PCB of claim 1, wherein at least one or at least two double-sided substrates are layered.

9. The PCB of claim 8, wherein the at least two double-sided substrates are layered and an insulation layer is formed between the double-sided substrates.

10. The PCB of claim 1, wherein the base layer is formed of the aluminum material, and surface treatment is performed to form surface roughness of the base layer.

11. The PCB of claim 1, wherein the circuit pattern is formed through any one of a chemical method and a mechanical method, or formed as a hole.

12. A method of manufacturing a printed circuit board (PCB), comprising:
providing an insulation layer of an insulating material;
bonding a base layer having a predetermined thickness to the insulation layer using a bonding member;
forming a double-sided substrate by forming a predetermined circuit pattern on the base layer;
forming a second insulation layer to fill the circuit pattern of the double-sided substrate;
bonding a second base layer of an aluminum material to the second insulation layer using a second bonding member;
forming a via hole penetrating the double-sided substrate, the second insulation layer, the second bonding member, and the second base layer;
forming a substitution layer by performing surface treatment to zincify a surface of the second base layer and a portion exposed to an inner side of the via hole;
forming a plating layer on the substitution layer using electrolytic or electroless plating; and
forming a second circuit pattern on the plating layer.

13. The method of claim 12, further comprising subsequent to the forming of the via hole:
forming a metal layer by metalizing a surface of the insulation layer and the bonding member of the double-sided substrate and the second insulation layer and the second bonding member, which is exposed to the inner side of the via hole, and
wherein the plating layer is formed to cover the metal layer.

14. The method of claim 13, wherein the forming of the substitution layer comprises forming the substitution layer to have a thickness equal to a thickness of the metal layer.

15. The method of claim 13, wherein the forming of the substitution layer comprises substituting zinc for a surface of the base layer and the insulation layer using a zincate method.

16. The method of claim 13, wherein the forming of the plating layer comprises forming the plating layer to cover a portion or an entirety of the metal layer.

17. The method of claim 16, wherein the forming of the plating layer comprises forming a substitution plating layer on a surface of the substitution layer using electrolytic or electroless plating, and forming an electrolytic plating layer of a cupric material on the substitution plating layer using the electrolytic plating.

18. The method of claim 12, further comprising:
forming surface roughness of the base layer prior to the bonding of the base layer to the insulation layer.

19. A method of manufacturing a printed circuit board (PCB), comprising:
providing an insulation layer of an insulating material;
bonding a base layer having a predetermined thickness to the insulation layer using a bonding member;
forming a double-sided substrate by forming a predetermined circuit pattern on the base layer;
layering at least two double-sided substrates in which the circuit pattern is formed;
forming an insulation layer between the layered double-sided substrates and on each of an upper face and a lower face of the layered double-sided substrates;
bonding a second base layer of an aluminum material to each of the upper face and the lower face of the layered double-sided substrates using a second bonding member;
forming a via hole penetrating the layered double-sided substrates, the second insulation layer, the second bonding member, and the second base layer;
forming a substitution layer by performing surface treatment to zincify a surface of the second base layer and a portion exposed to an inner side of the via hole;
forming a plating layer on the substitution layer using electrolytic or electroless plating; and
forming a circuit pattern on the plating layer.

20. The method of claim 19, further comprising subsequent to the forming of the via hole:
forming a metal layer to metalize a face of the insulation layer and the bonding member of the double-sided substrate, and the second insulation layer and the second bonding member, which is exposed to the inner side of the via hole.

21. The method of claim 20, wherein the forming of the substitution layer comprises forming the substitution layer to have a thickness equal to a thickness of the metal layer based on the thickness of the metal layer.

22. The method of claim 21, wherein the forming of the substitution layer comprises substituting zinc for a surface of the base layer and the insulation layer using a zincate method.

23. The method of claim 19, wherein the forming of the plating layer comprises forming a substitution plating layer on a surface of the substitution layer using electrolytic or electroless plating, and forming an electrolytic plating layer of a cupric material on the substitution plating layer using the electrolytic plating.

24. The method of claim 19, further comprising prior to the bonding of the base layer to the insulation layer:
forming surface roughness of the base layer.
